# EUROPEAN PATENT SPECIFICATION

(11) **EP 1 759 031 B1**
(45) Date of publication and mention of the grant of the patent: **05.12.2012**
(21) Application number: 05750129.8
(22) Date of filing: 26.05.2005
(51) Int. Cl.: C23C 14/06, C23C 30/00, F24J 2/48, F24J 2/46

(54) **SPECTRALLY SELECTIVE SURFACE COATING OF THE RECEIVER TUBE OF A SOLAR CONCENTRATOR, AND METHOD FOR THE MANUFACTURE THEREOF**
SPEKTRALSELEKTIVE OBERFLÄCHENBESCHICHTUNG DER EMPFANGSRÖHRE EINES SOLARKONZENTRATORS UND ZUGEHÖRIGES HERSTELLUNGSVERFAHREN
REVÊTEMENT DE SURFACE SPECTRALEMENT SÉLECTIVE DU TUBE DE RÉCEPTEUR D'UN CONCENTRATEUR SOLAIRE ET PROCÉDÉ DE FABRICATION DE CELUI-CI

(30) Priority: 07.06.2004 IT RM20040279
(43) Date of publication of application: 07.03.2007
(73) Proprietor: Enea-Ente Per Le Nuove Tecnologie, L'Energia e L'Ambiente, 00196 Roma (IT)
(72) Inventor: ANTONAIA, Alessandro, I-80055 Portici (NA) (IT); ESPOSITO, Salvatore, I-80055 Portici (NA) (IT); NOBILE, Giuseppe, I-84090 Giffoni Sei Casali (SA) (IT); APREA, Sabato, I-80147 Napoli (IT); ADDONIZIO, Maria Luisa, I-80055 Portici (NA) (IT)
(74) Representative: Sarpi, Maurizio
(86) International application number: PCT/IT2005/000304
(87) International publication number: WO 2005/121389

(56) References cited:
- WO-A-97/00335
- WO-A-2005/010225
- AU-B2- 538 944
- ZHANG Q-C: "Recent progress in high-temperature solar selective coatings" SOLAR ENERGY MATERIALS AND SOLAR CELLS, ELSEVIER SCIENCE PUBLISHERS, AMSTERDAM, NL, vol. 62, no. 1-2, April 2000 (2000-04), pages 63-74, XP004195297 ISSN: 0927-0248
- ZHANG Q-C ET AL: "NEW CERMET SOLAR COATINGS FOR SOLAR THERMAL ELECTRICITY APPLICATIONS" SOLAR ENERGY, PERGAMON PRESS. OXFORD, GB, vol. 64, no. 1/3, September 1998 (1998-09), pages 109-114, XP000667644 ISSN: 0038-092X
- ZHANG Q-C ET AL: "High performance W-AlN cermet solar coatings designed by modelling calculations and deposited by DC magnetron sputtering" SOLAR ENERGY MATERIALS AND SOLAR CELLS, ELSEVIER SCIENCE PUBLISHERS, AMSTERDAM, NL, vol. 81, no. 1, 25 January 2004 (2004-01-25), pages 25-37, XP004482760 ISSN: 0927-0248
- PATENT ABSTRACTS OF JAPAN vol. 013, no. 079 (C-571), 22 February 1989 (1989-02-22) -& JP 63 266068 A (NISSHIN STEEL CO LTD), 2 November 1988 (1988-11-02)

## Description

The present invention relates to solar installations for power production and particularly a novel material to be used as surface coating of a solar installation receiving tube, preferably of the linear, parabolic mirror type, adapted to operate at high temperatures. The receiving tube located along the focus line of the parabolic mirrors has the function of absorbing the highest amount of the concentrated solar radiation and, at the same time, dispersing outwards a minimum amount of the stored heat.

Presently, materials adapted to be used as surface coating of the receiving tube are optically selective, i.e. materials whose optical characteristics such as reflectance, absorbance, and hemispherical emissivity change considerably with the wavelength of the radiation from the irradiation region of the solar spectrum to the thermal IR region. The coating to be provided should have almost ideal characteristics: zero reflectance (unit absorbance) in the spectral region of the solar radiation (0.3-2.0 µm) and unit reflectance (zero absorbance and emissivity) in the thermal IR region (2.0-40 µm) with a stepped transition between the two regions.

Materials generally used as solar absorbers are the porous metals, degenerate semiconductors and "CERMET" which are composite ceramic-metal materials where nanometric particles are dispersed into a ceramic matrix.

In particular, CERMET are materials that comply with the requirements mentioned above as they have a high absorption capability in the solar spectrum region and are transparent in the thermal infrared region. In addition, they are stable enough when used at high temperatures. The interest to such composite materials began in 1950 as Tabor, Gier and Dunkle showed their first works regarding the use of CERMET as coating materials for the selective absorption of solar radiations. Since that time the selective absorption characteristics of a number of composite materials have been investigated, Cu, Ni, Co, Pt, Cr, Mo, W, Al and Ag being the most used metal materials, and the ceramic matrix consisting mostly of SiO, SiO₂, Al₂O₃, AlN and MgO. Some of these materials have been marketed to build mainly thermal solar power generation installations (from a few kW to tens of MW).

The selective absorbers made of the first composite materials consisted of a layer of CERMET with a homogeneous volume metal fraction between a metal layer as infrared reflector and a layer of a reflection preventing material allowing the absorption of the solar spectrum to be improved.

T. S. Sathiaray et al. deposited a layer of 70 nm of CERMET consisting of Ni-Al₂O₃ with a volume fraction of 0.21 Ni and covered the whole assembly by a reflection preventing layer of SiO₂ of 60 nm. This assembly had an absorption of 0.87 with an emissivity of 0.07 at 100°C. The emissivity of a number of such assemblies could be decreased by assuming a lower absorption rate, and the absorption could be improved by assuming a higher emissivity. In any case, the absorption rate obtained by this assembly was not high enough to be used for coating materials in thermoelectrical applications; moreover, as the operating temperature rose over 300°C, the emissivity increased strongly and the performance of the coating was degraded.

Therefore, surface coating with more complex structures were investigated to provide a higher absorption than 0.9 and as lower as possible emissivity at high temperatures. The first structure investigated had a varying content of metal dispersed into the ceramic matrix. A number of works made since 1977 showed the advantages achieved by putting a CERMET between metal reflector and reflection preventing layer with a volume fraction of metal decreasing from the metal reflector to the reflection preventing layer. Researches carried out in those years by I.T. Ritche and B. Window emphasized that the linear profile among the several profile of the ceramic matrix content maximized the solar absorption. The following researches, among others those carried out by Qi-Chu Zhang, emphasized that these materials showed an emissivity quickly increasing with the temperature even they had the maximum absorption possible. Such increase could be explained by two different aspects: the overlap of the wavelengths of the solar spectrum and the spectrum re-irradiated by the coating which increased with the increase in the temperature; the selectivity of the assembly with continuously varying profile which was not sharp from the solar spectrum low-reflectance region to the infrared high-reflectance region. To obviate to such behaviour of CERMET with continuously varying profile at high temperatures, Qi-Chu Zhang proposed an alternate structure consisting of several overlapped layers of CERMET having each different volume metal fractions between a metal reflector and a reflection preventing layer. By a suitable selection of the volume metal proportion in the CERMET layers the selective characteristics of the coating could be improved by shifting the transition between the low-reflectance region and the high-reflectance region, as it was the case in the structures with continuously varying linear profile, by changing the slope of the profile.

At last, a much sharper transition between the low reflectance at the solar spectrum and the high infrared reflectance could be achieved by changing the thickness of the layers to obtain the beneficial effects of the interference between the signals reflected by the different layers. Therefore, notwithstanding this structure could not be able to provide a comparable absorption as the structure with continuously varying profile, however, it was capable of ensuring as better performance as greater the operating temperature of the coating was.

Hitherto both structures, i.e. multilayered CERMET and CERMET with continuously varying linear profile, have found application in the trade of domestic and industrial installations for the production of hot water and power as well. It should be appreciated that the operating temperatures of the coating generally do not exceed 400°C so that the performance of the installations are comparable independently of the coating used.

Presently, two companies that are committed to produce solar collectors for high temperatures adapted for power generation are the Israeli SOLEL Solar Systems Company (ex Luz International Limited) and the Chinese TurboSun Energy Company. The technological approaches of the two Companies are quite different from the point of view of the collector construction and above all the CERMET used.

The Israeli Company, fortified by a now twenty-year experience matured on the United States installations, centred its researches and production on CERMET with continuously varying profile. The absorbance and emissivity values at 400°C provided by SOLEL are equal to 0.96 and 0.08, respectively. As far as the Chinese Company is concerned, the development line of its products runs through a double-layer CERMET (developed in cooperation with the Universities of Peking and Sidney). The marketed CERMET consists of AlN-SS (stainless steel)/Cu, the operating characteristics if which provided by the Company are: 0.94÷0.96 for the absorbance and a value lower than 0.10 at 350°C for the emissivity.

As it is self-evident from the foregoing, one major limit of the known CERMET coatings is the value of their maximum operating temperature that guarantees a good performance and stability in time. An useful parameter to compare the performances of the solar concentrators of the thermoelectrical installations is the photo-thermal conversion efficiency (ηₚₜ): 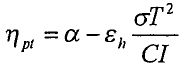 where α is the absorbance, εₕ the emissivity, σ the constant of Stefan-Boltzmann, T the temperature of the coating, I the irradiance of the direct component of the solar spectrum evaluated at AM 1.5, and C the concentration factor (opening of the mirror/circumference of the collector).

A first object of the invention is to provide a coating material for collector tubes provided with a good mechanical, structural stability in the whole operating temperature range which is far higher than the temperature range of use of the present coatings, in particular between 300 and 580°C.

A second object of the invention is to provide a coating material of the above-mentioned type able to provide a high absorbance in the whole spectrum of the solar radiation.

A third object of the invention is to provide a coating material of the above-mentioned type able to provide a low emissivity at the maximum operating temperature, preferably 580°C, in a solar installation for power production with the technology of linear, parabolic mirror.

A fourth object of the invention is to provide a coating material of the above-mentioned type able to provide an excellent performance in terms of high absorbance and low emissivity in the whole operating temperature range (300÷580°C) on the linear collector (0÷600 m) which implies the production of only one type of coating material with evident technological, economical advantages in the construction of the installation.

A fifth very important object of the invention is the use of methods of manufacturing the coating forming layers characterized by a high deposition rate on metal targets by reactive DC sputtering processes. The high deposition rate strongly influences the productivity and after all causes a strong reduction in the production cost.

This has been achieved according to the invention by providing a multilayer coating material according to claim 1, including a lower layer of preferably infrared reflecting metal, and an upper layer of reflection preventing material, between which one or two layers of a novel composite ceramic-metallic (CERMET) material are sandwiched. The ceramic matrix of CERMET consists of amorphous aluminium nitride (AlN), and the metal particles dispersed in the ceramic matrix consists of titanium nitride (TiNₓ) or zirconium nitride (ZrNₓ) or hafnium nitride (HfNₓ).

In case of only one CERMET layer, it is of the "graded" type, with the metal content decreasing from the lower substrate 1 to the reflection preventing upper layer 4.

In case of two CERMET layers, the lower CERMET layer has a greater volume metal fraction than that in the upper CERMET layer.

For the above-mentioned purposes, the CERMET materials are most flexible, most stable in temperature, and with the best performance in terms of high absorbance of the solar spectrum and low infrared emissivity.

A better understanding of the invention will result from the present description with reference to the accompanying drawings that show a preferred embodiment of the invention only by way of a not limiting example and the peculiar features of optical selectivity as well.

In the drawings:
Figure 1 shows the structure of the coating according to the invention relative to a first embodiment in which only one CERMET layer is sandwiched between the upper and lower layers, with three thin layers as a whole being provided;
Figure 2 shows the structure for the coating according to the invention relative to a second embodiment in which two CERMET layers are sandwiched between the upper and lower layers, with four thin layers as a whole being provided;

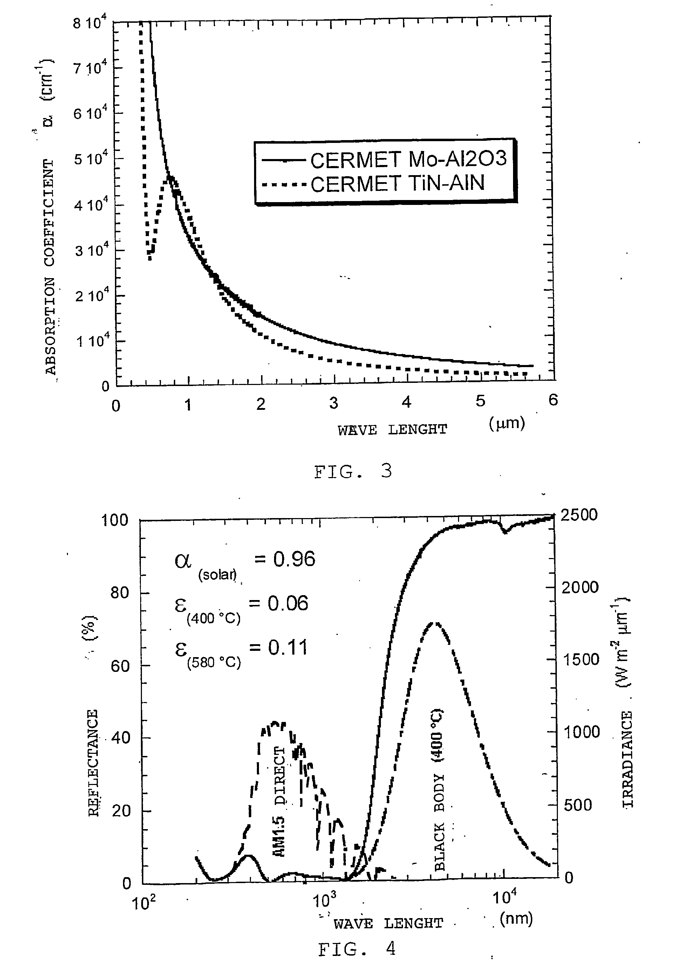

Figure 3 is a diagram obtained by experimental data and showing the comparison between the spectra of the absorption coefficients of a traditional CERMET (Mo-Al₂O₃) and a CERMET according to the invention (TiNₓ-AlN); and
Figure 4 is a diagram showing the experimental spectral reflectance of a coating with a double layer of CERMET TiNₓ-AlN made in laboratory according to the invention as well as the experimental data relative to important photo-thermal parameters, particularly the solar absorbance σ and the hemispherical emissivity ε evaluated at two different operating temperatures (400 and 580°C).

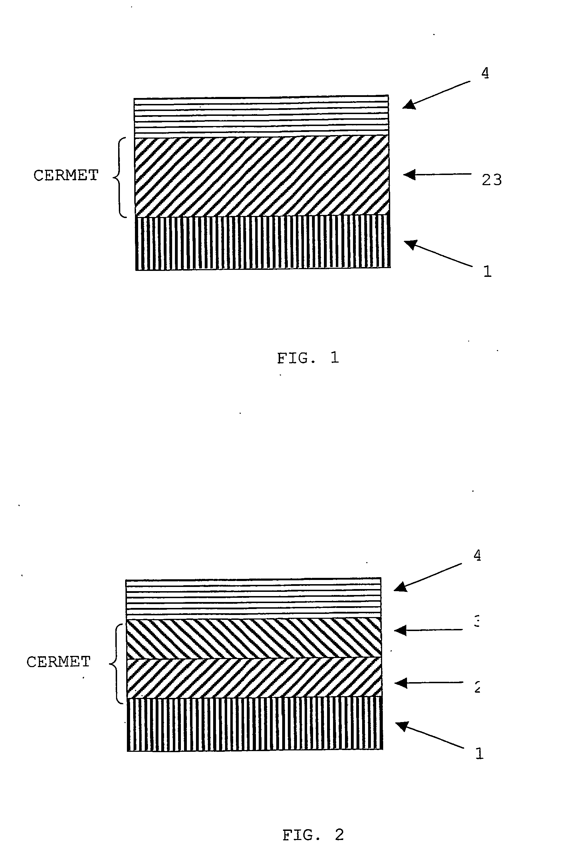

In the first embodiment with three layers of figure 1, the coating consists, from the lower substrate of steel, of:
- a lower layer 1 of metal such as W or ZrN (thickness ≈ 0.50 µm);
- an intermediate layer 23 of CERMET MNₓ-AlN (thickness 0.05 to 0.15 µm) of the "graded" type, where M is titanium or zirconium or hafnium, the metal content of which decreases from the lower substrate 1 to the reflection preventing upper layer 4;
- a reflection preventing upper layer 4 of ceramic material such as AlN or Al₂O₃ (thickness 0.02 to 0.10 µm).

In the second embodiment with four layers of figure 2, the coating consists, from the lower substrate of steel, of:
- a lower layer 1 of metal such as W or ZrN (thickness ≈ 0.50 pm);
- a first intermediate layer 2 of CERMET MNₓ-AlN (thickness 0.02 to 0.08 µm) with high metal content, where M is titanium or zirconium or hafnium;
- a second intermediate layer 3 of CERMET MNₓ-AlN (thickness 0.02 to 0.08 µm) having low metal content and overlapped on the preceding layer, where M is still titanium or zirconium or hafnium;
- a reflection preventing upper layer 4 of ceramic material such as AlN or Al₂O₃ (thickness 0.02 to 0.10 µm).

The present invention originates from the need for providing a novel material with selective properties regarding the wavelength of the solar radiation that allow it to be used as coating of the collectors of a linear concentration system of a solar thermoelectrical installation operating at middle-high temperatures. At the same time, there is the need for providing manufacturing methods at high deposition rate and, accordingly, at low production cost.

In other words, a coating is disclosed with a selective structure using a new composite metal-ceramic material or CERMET (TiNₓ-AlN or ZrNₓ-AlN or HfNₓ-AlN) which guarantees a photo-thermal conversion efficiency greater than 0.8 with a solar concentration factor of 26 at a maximum operating temperature of the installation equal to 580°C. This selective structure consists of at least three layers which are manufactured from metal target preferably by a DC sputtering technique. This technological aspect is really important if it is considered that generally, in the manufacturing of the CERMET layers and the ceramic layer, RF sputtering techniques should be resorted to, that are characterized, as well-known, by deposition rates which are very low and then little interesting as far as the industrial production is concerned.

At the time being reactive DC sputtering processes are proposed for the manufacturing of ceramic material such as the deposition of aluminium nitride (AlN) on aluminium targets in the presence of nitrogen gas or the deposition of silicon oxide (SiO₂) on silicon targets in the presence of oxygen gas, and so on. These processes face with and solve the problem of speeding up the manufacturing of the upper layer 4, the so-called "reflection preventing" layer. Vice versa, in the manufacturing of CERMET layers always using co-sputtering techniques quick reactive DC sputtering processes are used, thus it is necessary that the metal component of the composite material is resistant to nitriding in nitrogen plasma or resistant to oxidation in oxygen plasma. Such metals exist as far as the resistance to nitriding is concerned. For example, tungsten and steel are resistant enough to nitriding in nitrogen plasma. It follows that CERMET of W-AlN or SS-AlN type deposited by reactive DC co-sputtering technique on metal targets of tungsten and aluminium or steel and aluminium are already produced and marketed.

The main technological novelty of the present invention referring to the manufacturing of CERMET layers consists of the use of a metal (titanium or zirconium or hafnium) which is transformed advantageously into a product (titanium nitride or zirconium nitride or hafnium nitride) which retains metal properties through a reactive DC sputtering process even if a nitriding in nitrogen plasma takes place. According to the invention, this peculiar metal component will be finely dispersed into a ceramic matrix of aluminium nitride following a reactive DC co-sputtering process on two metal targets M and Al (where M is titanium or zirconium or hafnium) in nitrogen plasma. In other words, the inventive concept at the base of the invention consists of the use of a novel CERMET material in which both the component with metal properties and the component with ceramic properties are metal nitrides that can be obtained by reactive DC sputtering. According to a peculiar feature of the invention, this guarantees good mechanical, optical characteristics of the coating even at a maximum operating temperature of 580°C. These CERMET layers defined as mentioned above are sandwiched between an underlying layer of metal which is stable at high temperatures (W or ZrN) and has a high infrared reflectance and an overlying ceramic layer (AlN) with reflection preventing function.

In addition to the unquestionable technological manufacturing advantage, the spectrally selective coating disclosed above, compared with the hitherto used CERMET-layer coatings, ensures a considerably low hemispheric emissivity at high temperatures, under the same solar absorbance. In fact, the CERMET according to the invention is infrared-transparent more than the traditional CERMET, and this peculiarity brings a beneficial drop of the emissivity of the present selective coating.

In the end it should be appreciated that, as the coating material according to the invention is able to be used to coat a solar collector that extends along the focus line of the concentrators and reaches a maximum temperature of about 580°C, thus ensuring a temperature of the output fluid essentially equal to 550°C, the thermoelectrical efficiency of the installation coated according to the invention is advantageously greater than that of the hitherto used systems that operate at lower temperatures (<400°C) or resort to further heating till the optimum operating temperature.

In fact, according to the invention, the use of higher temperatures of the fluid allows high efficiencies of the turbine to be provided, as it is not necessary to heat the fluid before the input into the turbine wheel. In particular, for an operating temperature of 580°C, the material according to the present invention has an absorbance α>0.95; an emissivity εₕ<0.12; and a photothermal conversion efficiency ηₚₜ>0.80.

To sum up, the coating material according to the invention includes:
1. a lower layer of infrared reflecting metal 1 which consists of tungsten manufactured by DC sputtering technique or stoichiometric zirconium nitride (ZrN) manufactured by reactive DC sputtering;
2. an upper layer 4 of reflection preventing ceramic which consists of aluminium nitride (AlN) manufactured by reactive sputtering technique from an aluminium target in the presence of nitrogen (reactive gas) mixed with argon (sputtering gas), or alumina (Al₂O₃) manufactured by reactive sputtering technique from an aluminium target in the presence of oxygen (reactive gas) mixed with argon (sputtering gas);
3. a "graded" CERMET layer 23 or two homogeneous CERMET layers 2 and 3 which are manufactured by a reactive DC co-sputtering technique in the presence of nitrogen (reactive gas) mixed with argon (sputtering gas) from two metal targets, the first of which consists of aluminium and the second of titanium or zirconium or hafnium.

It results from the foregoing that an object of the present invention is also a method of manufacturing multilayer coatings for solar collectors.

Such method includes essentially the following steps:
A. providing a lower layer of infrared reflecting metal.1 which consists of: tungsten manufactured by DC sputtering technique or stoichiometric zirconium nitride (ZrN) manufactured by reactive DC sputtering;
B. providing an intermediate "graded" CERMET layer 23 or two intermediate, homogeneous overlapped CERMET layers 2 and 3 which are manufactured by a reactive DC co-sputtering technique in the presence of nitrogen as reactive gas mixed with argon as sputtering gas from two metal targets, the first of which consists of aluminium and the second of titanium or zirconium or hafnium;
C. providing an upper layer 4 of reflection preventing ceramic consisting of: aluminium nitride (AlN) manufactured by reactive sputtering technique from an aluminium target in the presence of nitrogen as reactive gas mixed with argon as sputtering gas, or alumina (Al₂O₃) manufactured by reactive sputtering technique from an aluminium target in the p'resence of oxygen as reactive gas mixed with argon as sputtering gas.

Accordingly, all of the layers of the selective coating disclosed above are produced by a DC sputtering technique ensuring a high deposition rate and then a high industrial productivity. Furthermore, such layers consists of materials which are very stable at high temperatures. At last, the high transparency of the CERMET (TiNₓ-AlN or ZrNₓ-AlN or HfNₓ-AlN) manufactured as mentioned above in the spectral infrared region over the hitherto used CERMET ensures a considerably low hemispherical emissivity at high temperatures, under the same solar absorbance.

The present invention has been described and illustrated according to preferred embodiments thereof, however, it is self-evident that anyone skilled in the art can make technically and functionally equivalent modifications and/or replacements without departing from the scope of the present industrial invention.

## Claims

1. A surface coating material for solar collector installations, particularly of the linear parabolic mirror type, **characterized in that** it consists of a multilayer structure including a lower layer of infrared reflecting metal (1) stable under vacuum and an upper layer of reflection preventing material (4), between which at least one layer (23) of composite ceramic-metal or CERMET material is sandwiched, the metal component of which is titanium nitride (TiNₓ) or zirconium nitride (ZrNₓ) or hafnium nitride (HfNₓ), and the ceramic component is aluminium nitride (AlN); said CERMET layer being deposited by reactive DC Co-sputtering technique and being of the graded type, with the metal content of which decreasing with continuity from the lower metal substrate (1) to the reflection preventing upper layer (4).

2. The coating material according to claim 1, **characterized in that** said at least one intermediate CERMET layer is manufactured by co-sputtering techniques at high deposition rate from metal targets and operating by a reactive DC sputtering process in the presence of nitrogen plasma added with argon.

3. The coating material according to claim 1, **characterized in that** said intermediate CERMET layer consists of two overlapped layers of composite ceramic-metallic material having different volume metal fraction, in which the underlying layer (2) has a higher volume metal fraction than that of the overlying layer (3).

4. The coating material according to claim 1, **characterized in that** said reflection preventing upper layer (4) consists of a ceramic layer of aluminium nitride (AlN) or alumina (Al₂O₃), said ceramic layer being manufactured at high deposition rate by a reactive DC sputtering technique in the presence of nitrogen plasma added with argon and in the presence of oxygen plasma added wit argon, respectively.

5. The coating material according to claim 1, **characterized in that** the lower metal layer (1) consists of infrared highly reflecting materials which are little diffusing at high temperatures, such as tungsten or zirconium nitride that can be both manufactured by a not reactive and reactive DC sputtering technique, respectively.

6. The coating material according to the preceding claims, **characterized in that** it is stable till an operating temperature of 584°C, thus reaching a maximum temperature of the working fluid equal to 550°C.

7. The coating material according to the preceding claims, **characterized in that** it has an absorbance α>0.95, an emissivity εₕ<0.12, and a photo-thermal conversion efficiency ηₚₜ>0.80 at an operating temperature of 580°C.

8. A method of manufacturing at surface coating material for collectors of solar installations, particularly of the linear parabolic mirror type, according to the preceding claims, characterized essentially by the following steps:
A. providing a lower layer of reflecting metal. (1) which consists of: tungsten manufactured by DC sputtering technique or stoichiometric zirconium nitride (ZrN) manufactured by reactive DC sputtering;
B. providing an intermediate graded CERMET layer (23) or two intermediate, homogeneous overlapped CERMET layers (2 and 3) which are manufactured by a reactive DC co-sputtering technique in the presence of nitrogen as reactive gas mixed with argon as sputtering gas from two metal targets, the first of which consists of aluminium and the second of titanium or zirconium or hafnium;
C. providing an upper layer (4) of reflection preventing ceramic consisting of: aluminium nitride (AlN) manufactured by reactive sputtering technique from an aluminium target in the presence of nitrogen as reactive gas mixed with argon as sputtering gas, or alumina (Al₂O₃) manufactured by reactive sputtering technique from an aluminium target in the presence of oxygen as reactive gas mixed with argon as sputtering gas.

## Patentansprüche

1. Oberflächenbeschichtungsmaterial für Sonnenkollektoranlagen, insbesondere des linearen parabolischen Spiegeltyps, **dadurch gekennzeichnet, dass** es aus einer Mehrlagenstruktur besteht, beinhaltend eine untere Schicht aus Infrarot-reflektierendem Metall (1), die stabil unter Vakuum ist, und einer oberen Schicht aus reflektionsminderndem Material (4), zwischen denen zumindest eine Schicht (23) eines Keramik-Metall-Komposits oder CERMET-Materials sandwichartig eingebracht ist, von dem die Metallkomponente Titannitrid (TiNₓ) oder Zirkoniumnitrid (ZrNₓ) oder Hafniumnitrid (HfNₓ) und die Keramik-Komponente Aluminiumnitrid (AlN) ist; wobei die CERMET-Schicht durch eine reaktive DC Co-Sputtering-Technik abgelagert ist und vom gradierten Typ ist, wobei der Metallgehalt davon kontinuierlich vom unteren Metallsubstrat (1) zur reflektionsmindernden oberen Schicht (4) abnimmt.

2. Beschichtungsmaterial gemäß Anspruch 1, **dadurch gekennzeichnet, dass** zumindest eine zwischenliegende CERMET-Schicht durch Co-Sputtering-Techniken bei hoher Ablagerungsrate aus Metall-Targets und Operieren durch einen reaktiven DC-Sputtering-Prozess in der Gegenwart von Stickstoffplasma, dem Argon zugefügt ist, hergestellt wird.

3. Beschichtungsmaterial gemäß Anspruch 1, **dadurch gekennzeichnet, dass** die zwischenliegende CERMET-Schicht aus zwei überlappenden Schichten von keramischmetallischem Kompositmaterial mit verschiedenen Volumen-Metallanteilen besteht, in denen die unten liegende Schicht (2) einen höheren Volumen-Metallanteil hat als die darüber liegende Schicht (3).

4. Beschichtungsmaterial gemäß Anspruch 1, **dadurch gekennzeichnet, dass** die reflektionsmindernde obere Schicht (4) aus einer keramischen Schicht von Aluminiumnitrid (AlN) oder Aluminiumoxid (Al₂O₃) besteht, wobei die keramische Schicht mit hoher Ablagerungsrate durch eine reaktive DC-Sputtering-Technik jeweils in der Gegenwart von Stickstoffplasma, dem Argon zugefügt ist, und in der Gegenwart von Sauerstoffplasma, dem Argon zugefügt ist, hergestellt wird.

5. Beschichtungsmaterial gemäß Anspruch 1, **dadurch gekennzeichnet, dass** die untere Metallschicht (1) aus Infrarot-hochreflektierenden Materialien besteht, die wenig diffundierend bei hohen Temperaturen sind, wie Wolfram oder Zirkoniumnitrid, welche beide jeweils durch eine nicht-reaktive und reaktive DC-Sputtering-Technik hergestellt werden können.

6. Beschichtungsmaterial gemäß den vorstehenden Ansprüchen, **dadurch gekennzeichnet, dass** es bis zu einer Betriebstemperatur von 580°C stabil ist, wodurch eine maximale Temperatur des Arbeitsfluids, die gleich 550°C ist, erreicht wird.

7. Beschichtungsmaterial gemäß den vorstehenden Ansprüchen, **dadurch gekennzeichnet, dass** es einen Absorptionsgrad α > 0,95, einen Emissionsgrad εₕ < 0,12, und eine fotothermale Umwandlungseffizienz ηₚₜ > 0,80 bei einer Betriebstemperatur von 580°C hat.

8. Verfahren zur Herstellung eines Oberflächenbeschichtungsmaterials für Kollektoren von Solaranlagen, insbesondere des linearen parabolischen Spiegeltyps, gemäß den vorstehenden Ansprüchen, im Wesentlichen charakterisiert durch die folgenden Schritte:
A. Bereitstellen einer unteren Schicht von reflektierendem Metall (1), welche besteht aus: durch DC-Sputtering Technik hergestelltes Wolfram oder durch reaktives DC-Sputtering hergestelltes stöchiometrisches Zirkoniumnitrid (ZrN);
B. Bereitstellen einer zwischenliegenden, gradierten CERMET-Schicht (23) oder zwei zwischenliegenden, homogen überlappenden CERMET-Schichten (2 und 3), die durch eine reaktive DC-Co-Sputtering Technik in der Gegenwart von Stickstoff als Reaktivgas, das mit Argon als Sputteringgas gemischt ist, aus zwei Metall-Targets hergestellt werden, wobei das erste aus Aluminium und das zweite aus Titan oder Zirkonium oder Hafnium besteht;
C. Bereitstellen einer oberen Schicht (4) aus reflektionsmindernder Keramik bestehend aus: durch eine reaktive Sputtering-Technik von einem Aluminium-Target in der Gegenwart von Stickstoff als Reaktivgas, welches mit Argon als Sputteringgas gemischt ist, hergestelltes Aluminiumnitrid (AlN), oder durch eine reaktive Sputtering-Technik von einem Aluminium-Target in der Gegenwart von Sauerstoff als Reaktivgas, das mit Argon als Sputteringgas gemischt ist, hergestelltes Aluminiumoxid (Al₂O₃).

## Revendications

1. Matériau de revêtement de surface pour des installations de capteurs solaires, en particulier du type à miroir parabolique linéaire, **caractérisé en ce qu'**il comprend une structure multicouche comprenant une couche inférieure de métal réfléchissant l'infrarouge (1) stable sous vide et une couche supérieure de matériau empêchant la réflexion (4), entre lesquelles au moins une couche (23) de matériau composite céramique-métallique ou CERMET est prise en sandwich, dont le composant métallique est le nitrure de titane (TiNₓ) ou le nitrure de zirconium (ZrNₓ) ou le nitrure de hafnium (HfNₓ) et le composant céramique est le nitrure d'aluminium (AlN) ; ladite couche de CERMET étant déposée par une technique de copulvérisation réactive à courant continu et étant du type graduel, avec la teneur en métal de celle-ci décroissant de manière continue du substrat métallique inférieur (1) à la couche supérieure empêchant la réflexion (4).

2. Matériau de revêtement selon la revendication 1, **caractérisé en ce que** ladite au moins une couche CERMET intermédiaire est fabriquée par des techniques de copulvérisation à haute vitesse de dépôt à partir de cibles de métal et fonctionnant par un processus de pulvérisation réactive à courant continu en présence de plasma d'azote additionné d'argon.

3. Matériau de revêtement selon la revendication 1, **caractérisé en ce que** ladite couche CERMET intermédiaire comprend deux couches superposées de matériau composite céramique-métallique ayant une fraction de métal en volume différente, où la couche sous-jacente (2) a une fraction de métal en volume supérieure à celle de la couche sus-jacente (3).

4. Matériau de revêtement selon la revendication 1, **caractérisé en ce que** ladite couche supérieure empêchant la réflexion (4) consiste en une couche de céramique de nitrure d'aluminium (AlN) ou d'alumine (Al₂O₃), ladite couche de céramique étant fabriquée à haute vitesse de dépôt par une technique de pulvérisation réactive à courant continu en présence de plasma d'azote additionné d'argon et en présence de plasma d'oxygène additionné d'argon, respectivement.

5. Matériau de revêtement selon la revendication 1, **caractérisé en ce que** la couche métallique inférieure (1) se compose de matériaux hautement réfléchissants à l'infrarouge qui sont de faible diffusion aux hautes températures, tels que le tungstène ou le nitrure de zirconium qui peuvent être tous deux fabriqués par une technique de pulvérisation à courant continu non réactive et réactive, respectivement.

6. Matériau de revêtement selon les revendications précédentes, **caractérisé en ce qu'**il est stable jusqu'à une température de fonctionnement de 580°C, en atteignant ainsi une température maximale du fluide de travail égale à 550°C.

7. Matériau de revêtement selon les revendications précédentes, **caractérisé en ce qu'**il a une absorbance α > 0,95, une émissivité εₕ < 0,12 et un rendement de conversion photo-thermique ηₚₜ > 0,80 à une température de fonctionnement de 580°C.

8. Procédé de fabrication d'un matériau de revêtement de surface pour des capteurs d'installations solaires, en particulier du type à miroir parabolique linéaire, selon les revendications précédentes, caractérisé essentiellement par les étapes suivantes :
A. prédisposer une couche inférieure de métal réfléchissant (1) qui se compose de : tungstène fabriqué par une technique de pulvérisation à courant continu ou nitrure de zirconium stoechiométrique (ZrN) fabriqué par pulvérisation réactive à courant continu ;
B. prédisposer une couche CERMET graduelle intermédiaire (23) ou deux couches CERMET superposées homogènes intermédiaires (2 et 3) qui sont fabriquées par une technique de copulvérisation réactive à courant continu en présence d'azote comme gaz réactif mélangé avec l'argon comme gaz de pulvérisation à partir de deux cibles de métal, la première qui se compose d'aluminium et la deuxième de titane ou de zirconium ou d'hafnium ;
C. la prédisposition d'une couche supérieure (4) de céramique empêchant la réflexion se composant de : nitrure d'aluminium (AlN) fabriqué par une technique de pulvérisation réactive à partir d'une cible d'aluminium en présence d'azote comme gaz réactif mélangé avec l'argon comme gaz de pulvérisation ou alumine(Al₂O₃) fabriquée par une technique de pulvérisation réactive à partir d'une cible d'aluminium en présence d'oxygène comme gaz réactif mélangé avec l'argon comme gaz de pulvérisation
